# EUROPEAN PATENT APPLICATION

(11) **EP 4 848 590 A1**
(43) Date of publication of application: **02.12.2026**
(21) Application number: 25179940.9
(22) Date of filing: 30.05.2025
(51) Int. Cl.: H03K 17/96, H03K 17/965

(54) **SWITCH FOR VOLTAGE INDICATION DEVICE**

(71) Applicant: Siemens Aktiengesellschaft, 80333 München (DE)
(72) Inventor: R P, Dipu, 629175 Kanyakumari, Tamil Nadu (IN); THAKUR, CHAITANYA, 423105 Nashik, Maharashtra (IN); DWIVEDI, Sunil, 403602 South Goa (IN); P N, Shrikantha, 574218 Dakshina Kannada (IN); KUMAR, Ajay, 403602 Fatorda, Goa (IN); P J, Subramanian, 673004 Kozhikode, Kerala (IN)
(74) Representative: Patentanwaltskanzlei WILHELM & BECK

(57) **Abstract**

A switch (100) for a voltage indication device (1000). The switch (100) includes a piezoelectric sensor (108) placed in a housing in the voltage indication device (1000). The piezoelectric sensor (108) is characterized by a convex protrusion (112) over the housing of the piezoelectric sensor (108) which is configured to provide tactile feedback in response to application of a mechanical force on the switch (100). The housing includes a first zone (104) with recessed cavity for securing the piezoelectric sensor (108), a second zone (102) comprising a flexure region around the first zone (104), the flexure region for enabling the piezoelectric sensor (108) to deform elastically under the applied mechanical force, and a third zone (106) with a cable channel for routing of a cable (110) of the piezoelectric sensor (108), wherein the cable (110) connects the piezoelectric sensor (108)to a display of the voltage indication device (1000).

## Description

The invention pertains to a voltage indication device. More particularly, the invention is associated with - a piezo-integrated test switch for a voltage indication device which includes round embossing for enabling feather touch interaction.

A Voltage Detecting and Indicating System (VDIS) is a safety measure used in medium and high voltage distribution networks to indicate the presence or absence of operating voltage, as specified by IEC 62271-213. The VDIS detects voltage from a primary source and displays an indication of percentage of this voltage on a display screen such as for example but not limited to a liquid crystal display (LCD) screen, utilizing predetermined graphics for clarity and may also include remote signaling capabilities. The VDIS helps ensure personnel safety during maintenance and repairs by clearly signaling when a circuit is energized.

Further, according to the IEC 62271-213, it is required to include a test switch in the VDIS to verify that the display screen is operational. However, conventional test switch available on the VDIS require excessive mechanical force to operate the test switch and no tactile feedback is provided to a user for a switch press, making them less user-friendly and inconvenient. Also, since the users are operating in high-voltage environments they could be wearing gloves and hence the test switches should be such that it does not generate false triggers or accidental contact. Also, in a scenario when there is a fault in the display of the VDIS the user may not be able to identify if the fault is actually in the display of the VDIS or in the manner of the switch press due to the absence of the tactile feedback.

In light of the above, there exists a need for a test switch which is easy to operate in the high-voltage environments. The switch press should be feather-like along with tactile feedback to ensure that the user is aware when there is a switch press, so that the user is able to identify if the fault is actually in the display of the VDIS or in the manner of the switch press.

Accordingly, it is an object of the invention to overcome the drawbacks of the state of the art. The object of the invention is achieved by independent claim 1 and all the corresponding dependent claims thereof.

The above-mentioned drawbacks are overcome by providing the test switch comprising a piezoelectric sensor placed in a housing of the VDIS with a convex protrusion over the housing. This convex protrusion over the housing of the piezoelectric sensor provides tactile feedback in response to application of a mechanical force on the switch by the user. Also, the housing has multiple zones which includes zone for the placement of the piezoelectric sensor, zone for enabling a deformation of the piezoelectric sensor and a zone also for routing of cable from the piezoelectric sensor.

The convex protrusion over the housing of the piezoelectric sensor also enables a delayed feedback in the piezoelectric sensor. This delayed feedback enables the piezoelectric sensor to remain energized for a specific period of time after the application of the mechanical force by the user. Therefore, there is no requirement of a powering medium to energize the piezoelectric sensor. As a result, the proposed solution provides a comprehensive solution to address the problems enlisted above. The proposed solution also ensures that the test switch is operative is high-voltage environments with users with ease by providing the feather-like touch of the test switch.

Accordingly, embodiments herein disclose a switch for a voltage indication device. The switch includes a piezoelectric sensor placed in a housing in the voltage indication device. The piezoelectric sensor is characterized by a convex protrusion over the piezoelectric sensor and providing tactile feedback in response to application of a mechanical force on the switch. The housing includes a first zone with recessed cavity for securing the piezoelectric sensor, a second zone comprising a flexure region around the first zone, the flexure region for enabling the piezoelectric sensor to deform elastically under the applied mechanical force, and a third zone with a cable channel for routing of a cable of the piezoelectric sensor, wherein the cable connects the piezoelectric sensor to a display of the voltage indication device.

In one or more embodiments, the convex protrusion over the piezoelectric sensor enables a delayed feedback in the piezoelectric sensor and wherein the delayed feedback enables the piezoelectric sensor to remain energized for a specific period of time and this feature helps the user to visualize smoothly.

In one or more embodiments, the switch is used to verify operationality of the display of the voltage indication device as per IEC 62271-213.

In one or more embodiments, the mechanical force is converted to electrical energy by the piezoelectric sensor.

In one or more embodiments, the deformation of the piezoelectric sensor generates proportional voltage for energizing the display of the voltage indication device.

In one or more embodiments, the switch further includes a force amplification layer embedded beneath the convex protrusion, configured to concentrate the applied mechanical force onto the piezoelectric sensor.

In one or more embodiments, the convex protrusion provides tactile feedback with an actuation pressure of less than 0.5 N, enabling operation of the switch via feather-touch interaction.

In one or more embodiments, an anti-static coating is provided on the convex protrusion to prevent sparking in explosive atmospheres.

Accordingly, embodiments herein disclose a voltage indication device. The voltage indication device includes a display of the voltage indication device and a switch for verifying operationality of the display of the voltage indication device. The switch includes a piezoelectric sensor placed in a housing in the voltage indication device. The piezoelectric sensor is characterized by a convex protrusion over the piezoelectric sensor and providing tactile feedback in response to application of a mechanical force on the switch. The housing includes a first zone with recessed cavity for securing the piezoelectric sensor, a second zone comprising a flexure region around the first zone, the flexure region for enabling the piezoelectric sensor to deform elastically under the applied mechanical force, and a third zone with a cable channel for routing of a cable of the piezoelectric sensor, wherein the cable connects the piezoelectric sensor to a display of the voltage indication device.

Advantageously, such test switches ensures that there is tactile feedback provided to the user, so that in scenarios where there is a fault in the display of the VDIS then the user is sure that the fault is not due to damage in the test switch. Since there is also the feather-touch interaction provided due to the housing and the zoning within the test switch this ensures easy testing of the display by the users, who could be wearing gloves due to the high-voltage environment.

The above mentioned and other features of the invention will now be addressed with reference to the accompanying drawings of the present invention. The illustrated embodiments are intended to illustrate but not limit the invention.

The present invention is further described hereinafter with reference to illustrated embodiments shown in the accompanying drawings, in which:
- FIG 1: illustrates a perspective view of a housing for switch for a voltage indication device, in accordance with an embodiment of the present invention;
- FIG 2: illustrates exploded view of the switch in the voltage indication device, in accordance with an embodiment of the present invention; and
- FIG 3: illustrates a sectioned side view of the switch for the voltage indication device, in accordance with an embodiment of the present invention.

Various embodiments are described with reference to the drawings, wherein like reference numerals are used to refer like elements throughout. In the following description, for the purpose of explanation, numerous specific details are set forth in order to provide thorough understanding of one or more embodiments. It may be evident that such embodiments may be practiced without these specific details.

Examples of a switch for a voltage indication device are disclosed herein. In the following description, for the purposes of explanation, numerous specific details are set forth in order to provide a thorough understanding of the embodiments of the disclosure. It is apparent, however, to one skilled in the art that the embodiments of the disclosure may be practiced without these specific details or with an equivalent arrangement. In other instances, well-known structures and devices are shown in block diagram form in order to avoid unnecessarily obscuring the embodiments of the disclosure.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate but not limit the invention. Further, it may be noted that throughout the description the terms "switch" and "test switch" may be used interchangeably and means the same. Though the proposed solution is described with respect to test switch used in VDIS, the solution is extendable to any switch with piezoelectric sensors. Also, the terms voltage indication device and voltage detecting and indicating system (VDIS) may be used interchangeably and means the same.

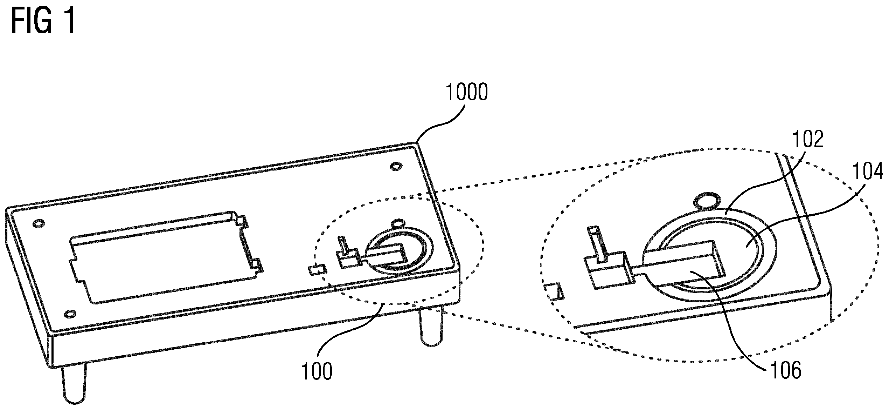

The present invention is further described hereinafter with reference to illustrated embodiments shown in the accompanying drawings, in which: FIG 1 illustrates a perspective view of a housing for switch 100 for a voltage indication device 1000, in accordance with an embodiment of the present invention. The voltage detecting and indicating system (VDIS) 1000 is a safety measure used in medium and high voltage distribution networks to indicate the presence or absence of operating voltage, as specified by IEC 62271-213. The VDIS detects voltage from a primary source and displays a percentage of this voltage on a display screen with predetermined graphics for clarity and may also include remote signaling capabilities. The VDIS 1000 helps ensure personnel safety during maintenance and repairs by clearly signaling when a circuit is energized. However, the standard IEC 62271-213 requires that a test switch 100 is included in the VDIS 1000 to verify that the display screen is operational.

The VDIS 1000 includes a housing which includes multiple cavities for providing the piezoelectric sensor, light indicators, and relay contacts for monitoring of voltage statuses and power status, etc. After the placement of the above-mentioned elements in the dedicated cavities the housing of the VDIS 1000 is sealed with a decal 114 or a sticker 114. The decal 114 or the sticker 114 is generally made of plastic, or allied substances.

In embodiments of the present disclosure, the proposed switch 100 includes a piezoelectric sensor 108 which is placed in a housing in the voltage indication device 1000. The switch 100 is used to verify operationality of the display of the voltage indication device 1000 as per IEC 62271-213. The standard IEC 62271-213 is applicable to the VDIS to be installed on indoor and outdoor high-voltage equipment. The piezoelectric sensor 108 is characterized by a round embossing or convex protrusion 112 which is provided in the decal 114 covering the housing of the piezoelectric sensor 108. The convex protrusion 112 in the decal 114 covering the housing of the piezoelectric sensor 108 is configured to provide tactile feedback in response to application of a mechanical force on the switch 100 by pressing the switch 100 by the user.

The convex protrusion 112 provides the tactile feedback due to a raised or indented surface which allows the users to feel the raised areas or indentations. This can enhance the user experience by providing a more intuitive and accurate way to interact with the switch 100. The tactile feedback provides the users with confirmation that their actions have been registered, like a click sound or a subtle vibration. Therefore, in a scenario when the display of the VDIS 1000 is faulty then the user is sure of the faulty condition and is not confused if the fault is arising due to erroneous pressing of the switch 100. The erroneous pressing of the switch 100 could occur in the high-voltage environment as the users may wear gloves while operating the VDIS 1000. The piezoelectric sensor 108 detects a change of state of the switch 100 and provides the tactile feedback to the user - in response to the detected change of state of the switch 100. Here, a state of the switch 100 is the display is operative indicated by the ON state.

The convex protrusion 112 over the piezoelectric sensor 108 enables delayed feedback in the piezoelectric sensor 108 and the delayed feedback enables the piezoelectric sensor 108 to remain energized for a specific period of time. The convex protrusion 112 provides tactile feedback with an actuation pressure of less than 0.5 N, enabling operation of the switch 100 via feather-touch interaction. Further, the switch 100 also includes a force amplification layer embedded beneath the convex protrusion 112 and is configured to concentrate the applied mechanical force onto the piezoelectric sensor 108. This will further enhance the feather touch interactions with the switch 100. An anti-static coating is also provided on the convex protrusion 112 to prevent sparking in explosive high voltage atmospheres.

Further, the housing of the proposed switch 100 comprises multiple zones, which includes but may not be limited to a first zone 104 with recessed cavity for securing the piezoelectric sensor 108 and a second zone 102 comprising a flexure region around the first zone 104 for enabling the piezoelectric sensor 108 to deform elastically under the applied mechanical force. A shape of the first zone 104 is corresponding to a shape of the piezoelectric sensor 108.The housing also includes a third zone 106 with a cable channel for routing of a cable 110 of the piezoelectric sensor 108. The cable 110 connects the piezoelectric sensor 108 to the display of the voltage indication device 1000. The third zone 106 overlaps a portion of the first zone 104 and the second zone 102. Further, a hermetic seal is added between the first, second, and third zones to prevent the passage of gases, liquids, and other contaminants into or out of the switch 100.

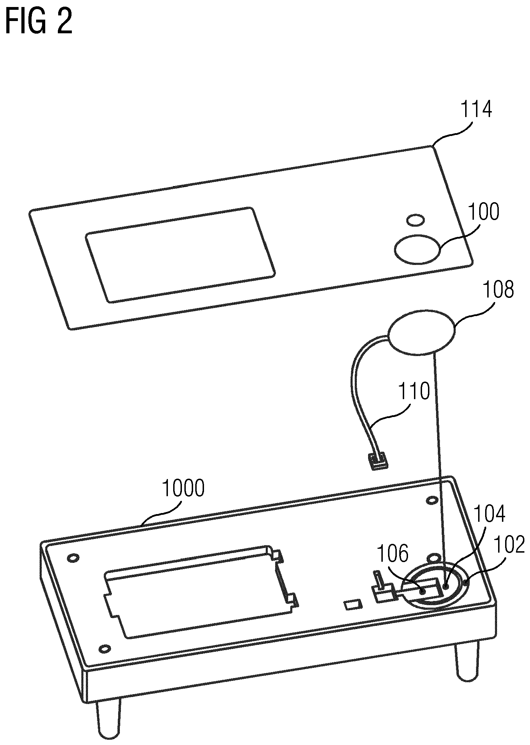

FIG 2 illustrates exploded view of the switch 100 in the voltage indication device 1000, in accordance with an embodiment of the present invention. Referring to the FIG. 2, the decal 114 to cover the housing is indicated. After the placement of the piezoelectric sensor 108 and the cable 110, etc in the dedicated cavities the housing of the VDIS 1000 is sealed with the decal 114 or a sticker 114. The decal 114 or the sticker 114 is generally made of plastic or allied substances.

Further, the piezoelectric sensor 108 along with the cable 110 is shown. The piezoelectric sensor 108 is accommodated in the first zone 104 with the recessed cavity for securing the piezoelectric sensor 108. The cable 110 is accommodated in the third zone 106 with the cable channel for routing of the cable 110 of the piezoelectric sensor 108. The cable 110 connects the piezoelectric sensor 108 to the display of the voltage indication device 1000. The decal portion of the entire switch 100 is provided which includes the convex protrusion 112. This convex protrusion 112 in the decal 114 covering the housing of the piezoelectric sensor 108 is configured to provide tactile feedback in response to application of the mechanical force.

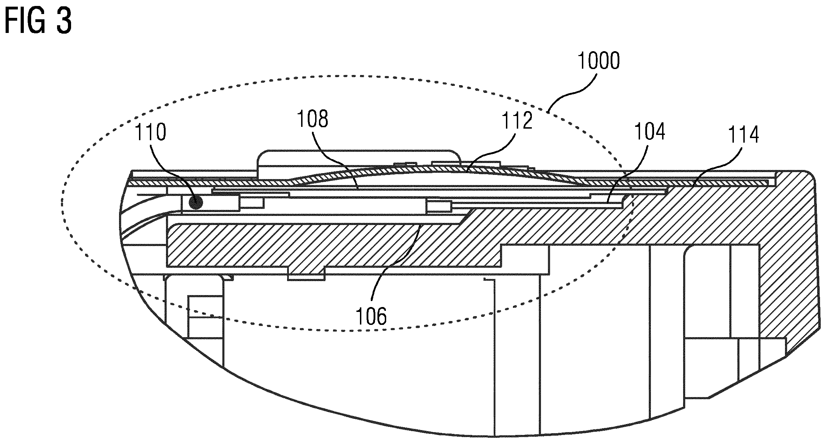

FIG 3 illustrates a sectioned side view of the switch 100 for the voltage indication device 1000, in accordance with an embodiment of the present invention. Here, the positioning of the convex protrusion 112 or the round embossing 112 in the test switch 100 and the piezoelectric sensor 108 located beneath it. The functionality of the piezoelectric sensor 108 is reliable while significantly improving the overall user experience of the switch 100. The tactile feedback is an added benefit with this approach.

The soft-touch approach of the switch 100 significantly enhances the conventional switch by minimizing the effort required to activate the switch 100. The proposed switch 100 improves user convenience by providing a more responsive and effortless interaction, making it easier for users to operate the VDIS 1000. Unlike traditional switches that require considerable force to engage, the soft-touch mechanism ensures that even a light touch can trigger the switch effectively. This not only reduces user fatigue during prolonged use but also enhances overall accessibility for individuals with varying strength levels. As a result, this advancement represents a substantial improvement in user experience, aligning with modern ergonomic standards.

Advantageously, the convex protrusion 112 in the proposed switch 100 provides improved usability of the switch 100 as the convex protrusion 112 makes it easier to interact with VDIS 1000 and by providing the tactile feedback. It also provides enhanced user experience and increases accessibility, as these test switches 100 can also be operated by users with visual impairments.

Thus, the conventional test switches require significant pressure to verify whether display of the voltage indication device 1000 is functioning properly, which detracts from user-friendliness. Unlike the conventional test switches, the proposed switch 100 provides an ergonomic touch feature that employs a round embossing 112 or the convex protrusion 112 on the switch's surface, optimizing the user experience without compromising the performance of the piezoelectric sensor 108 beneath the test switch 100.

The sensor of the test switch 100 is made from piezoelectric material that converts mechanical pressure into electrical energy. When a user applies a light touch to the round embossing 112, it activates the piezoelectric sensor 108, enabling it to generate energy effectively. The round embossing 112 also incorporates delayed feedback, allowing the piezo to remain energized for an extended period, which ensures responsiveness of the piezoelectric sensor 108.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope.

### Reference Numerals

| | |
|---|---|
| voltage indication device | 1000 |
| switch | 100 |
| piezoelectric sensor | 108 |
| first zone | 104 |
| second zone | 102 |
| third zone | 106 |
| cable | 110 |
| Decal | 114 |
| convex protrusion | 112 |

## Claims

1. A switch (100) for a voltage indication device (1000), wherein the switch (100) comprises:
a piezoelectric sensor (108) placed in a housing in the voltage indication device (1000), wherein the piezoelectric sensor (108) is **characterized by**
a convex protrusion (112) over the housing of the piezoelectric sensor (108) and the convex protrusion (112) over the housing of the piezoelectric sensor (108) is configured to provide tactile feedback in response to application of a mechanical force on the switch (100);
wherein the housing comprises:
a first zone (104) with recessed cavity for securing the piezoelectric sensor (108),
a second zone (102) comprising a flexure region around the first zone (104), the flexure region for enabling the piezoelectric sensor (108) to deform elastically under the applied mechanical force, and
a third zone (106) with a cable channel for routing of a cable (110) of the piezoelectric sensor (108), wherein the cable (110) connects the piezoelectric sensor (108)to a display of the voltage indication device (1000).

2. The switch (100) according to the claim 1, wherein the convex protrusion (112) over the piezoelectric sensor (108) enables a delayed feedback in the piezoelectric sensor (108) and wherein the delayed feedback enables the piezoelectric sensor (108) to remain energized for a specific period of time.

3. The switch (100) according to the claim 1, wherein the switch (100) is used to verify operationality of the display of the voltage indication device (1000) as per IEC 62271-213.

4. The switch (100) according to the claim 1, wherein a shape of the first zone (104) is corresponding to a shape of the piezoelectric sensor (108).

5. The switch (100) according to the claim 1, wherein the third zone (106) overlaps a portion of the first zone (104) and the second zone (102).

6. The switch (100) according to the claim 1, further comprising:
a force amplification layer embedded beneath the convex protrusion (112), configured to concentrate the applied mechanical force onto the piezoelectric sensor (108).

7. The switch (100) according to the claim 1, wherein the convex protrusion (112) provides tactile feedback with an actuation pressure of less than 0.5 N, enabling operation of the switch (100) via feather-touch interaction.

8. The switch (100) according to the claim 1, wherein an anti-static coating is provided on the convex protrusion (112) to prevent sparking in explosive atmospheres.

9. A voltage indication device (1000), wherein the voltage indication device (1000) comprises a switch (100) disclosed according to any of the claims 1 to 8.
